# EUROPEAN PATENT SPECIFICATION

(11) **EP 4 333 036 B1**
(45) Date of publication and mention of the grant of the patent: **28.10.2026**
(21) Application number: 23194338.2
(22) Date of filing: 30.08.2023
(51) Int. Cl.: H10P 72/00

(54) **SUBSTRATE PROCESSING APPARATUS**
VORRICHTUNG ZUR BEARBEITUNG VON SUBSTRATEN
APPAREIL DE TRAITEMENT DE SUBSTRAT

(30) Priority: 05.09.2022 JP 2022141077
(43) Date of publication of application: 06.03.2024
(73) Proprietor: SCREEN Holdings Co., Ltd., Kyoto-shi, Kyoto 602-8585 (JP)
(72) Inventor: KOMORI, Jun, Kyoto-shi, 602-8585 (JP)
(74) Representative: Kilian Kilian & Partner mbB

(56) References cited:
- JP-B2- 5 829 927
- KR-A- 20060 074 538
- KR-B1- 101 317 102
- US-A1- 2005 121 059
- US-A1- 2020 004 156

## Description

### BACKGROUND

### Technical Field

The present invention relates to a substrate processing apparatus that performs processing on a substrate using a processing liquid.

### Description of Related Art

Conventionally, a substrate processing apparatus is used to perform predetermined processing using a processing liquid on various substrates such as a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate or a substrate for a solar cell. As such a substrate processing apparatus, there is a development device that performs development processing on a photosensitive film using a development liquid.

For example, JP 2002-246292 A describes a development processing device having a plurality of nozzles. The plurality of nozzles are held by an arm that is provided to be movable on a rail by a moving mechanism. The plurality of nozzles wait at waiting positions outward of a wafer during a period in which development processing is not performed. The plurality of nozzles is moved to positions upward of the wafer and then lowered to supply a development processing liquid to a surface of the rotating wafer during a period in which the development processing is performed. Further prior art is US 2020/004156 A1 and KR 2006 0074538 A, wherein US 2020/004156 A1 shows a leakage handling device in a semiconductor manufacturing apparatus which is directed on preventing lithography apparatus failures, wherein the leakage handling device includes a container for capturing a fluid leakage such as a coolant leaked from a circulation pipe or a coating material leaked from a photoresist pipe in order to prevent the fluid from dropping on a wafer. In KR 2006 0074538 A failure of a development liquid spray nozzle can be monitored in real-time during the process of wafers to be processed, wherein dropping of liquid on wafer is to be prevented.

### SUMMARY

Pipes for supplying a processing liquid are connected to the nozzles. The pipes are also configured to be movable in a case where the nozzles are movable. However, if the pipes are configured to be movable, deformation such as expansion and contraction, bend or twist repetitively occurs on movable portions of the pipes, so that the pipes are liable to be damaged. In particular, as described in JP 2002-246292 A, in a case where the plurality of nozzles are arranged in proximity to one another, the pipes rub against one another and thus are more liable to be broken.

If the pipes are damaged, processing of substrates cannot be appropriately performed. Also, if the processing liquid is scattered from damaged parts of the pipes, the substrate processing apparatus is contaminated or damaged. As such, it is required to prevent an adverse effect caused by leakage of liquid.

An object of the present invention is to provide a substrate processing apparatus capable of preventing an adverse effect caused by leakage of liquid. This object is achieved by the subject matter of the independent claim.

The invention is defined by the independent claim 1. Preferred embodiments are the subject matter of the dependent claims. Aspects of the invention are set out below. A substrate processing apparatus according to one aspect of the present invention includes a nozzle that discharges a processing liquid to a substrate to be processed, a pipe connected to the nozzle, a protective pipe that surrounds an outer periphery of the pipe, a nozzle driver that moves the nozzle, and a leak sensor that detects a leak liquid from the pipe.

According to the present invention, an adverse effect caused by leakage of liquid in a substrate processing apparatus can be prevented.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic perspective view for explaining the schematic configuration of a development device according to one embodiment of the present invention;
Fig. 2 is a partially exploded perspective view for explaining the configuration of a liquid processing unit of Fig. 1;
Fig. 3 is a schematic plan view for explaining the configuration of a part of the liquid processing unit of Fig. 2;
Fig. 4 is a schematic longitudinal cross sectional view for explaining the configuration of a part of the liquid processing unit of Fig. 2;
Fig. 5 is a perspective view of a nozzle arm unit of Fig. 2;
Fig. 6 is a longitudinal cross sectional view of the nozzle arm unit taken along a predetermined vertical plane;
Fig. 7 is an external perspective view of a partition plate and a cylindrical member of Fig. 2;
Fig. 8 is a plan view of the partition plate and the cylindrical member of Fig. 2;
Fig. 9 is a diagram for explaining the operation of the nozzle arm unit when a plurality of nozzles move between a waiting position and a processing position;
Fig. 10 is a diagram for explaining the operation of the nozzle arm unit when the plurality of nozzles move between the waiting position and the processing position;
Fig. 11 is a diagram for explaining the operation of the nozzle arm unit when the plurality of nozzles move between the waiting position and the processing position;
Fig. 12 is a diagram for explaining the operation of the nozzle arm unit when the plurality of nozzles move between the waiting position and the processing position;
Fig. 13 is a schematic cross sectional view for explaining the configuration of a protective pipe;
Fig. 14 is a perspective view of a unit base;
Fig. 15 is a plan view of the unit base of Fig. 14;
Fig. 16 is a schematic cross sectional view of the development device;
Fig. 17 is a schematic longitudinal cross sectional view of the development device when a cup of each of the liquid processing units is in a second state;
Fig. 18 is a schematic longitudinal cross sectional view of the development device during development processing for a substrate;
Fig. 19 is a block diagram showing the configuration of a controller of the development device 1 of Fig. 1; and
Fig. 20 is a flowchart showing a basic operation during the development processing for the substrate by the development device.

### DETAILED DESCRIPTION

A substrate processing apparatus according to embodiments of the present invention will be described below with reference to the drawings. In the following description, a substrate refers to a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate, a substrate for a solar cell or the like.

A development device will be described as one example of the substrate processing apparatus. A substrate subjected to development processing in the present embodiment has a main surface and a back surface. Further, in the development device according to the present embodiment, with the main surface of the substrate directed upwardly and the back surface of the substrate directed downwardly, the back surface (lower surface) of the substrate is held, and development processing is performed on the main surface (upper surface) of the substrate.

A photosensitive film on which exposure processing has been performed is formed at least in the center portion of the main surface of the substrate. This photosensitive film is a negative photosensitive polyimide film, for example. As a development liquid for dissolving the exposed negative photosensitive polyimide film, an organic solvent including cyclohexanone, cyclopentanone or the like is used. As a rinse liquid, an organic solvent including isopropyl alcohol, propylene glycol monomethyl ether acetate (PGMEA) or the like is also used.

In the present embodiment, "development processing for a substrate" means dissolution of a part of a photosensitive film by supply of a development liquid to the photosensitive film on which exposure processing has been performed and which is formed on the main surface of the substrate.

### 1. Configuration of Development Device

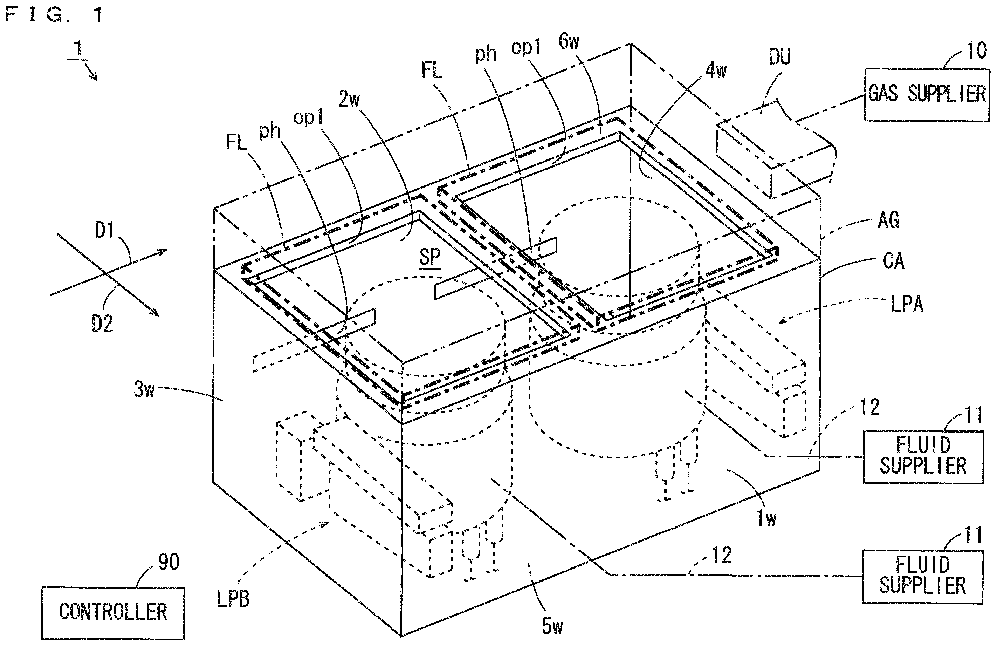

Fig. 1 is a schematic perspective view for explaining the schematic configuration of a development device according to one embodiment of the present invention. As shown in Fig. 1, the development device 1 basically has a configuration in which two liquid processing units LPA, LPB are contained in a casing CA. In Fig. 1, the schematic shapes of the two liquid processing units LPA, LPB are indicated by the dotted lines. Details of the configuration of the liquid processing units LPA, LPB will be described below.

The casing CA has a substantially cuboid box shape extending in one direction in a horizontal plane. Specifically, a first sidewall plate 1w, a second sidewall plate 2w, a third sidewall plate 3w, a fourth sidewall plate 4w, a bottom plate 5w and a top plate 6w are attached to a frame (not shown) to form the casing CA. In the following description, a direction parallel to the direction in which the casing CA extends in the horizontal plane is referred to as a first direction D1, and a direction orthogonal to the first direction D1 in the horizontal plane is referred to as a second direction D2. The two liquid processing units LPA, LPB are arranged on a unit base, described below, so as to be aligned in the first direction D1 in the casing CA.

The first and second sidewall plates 1w, 2w each have a rectangular plate shape and are provided so as to be parallel to a vertical direction and the first direction D1 and face each other. The first and second sidewall plates 3w, 4w each have a rectangular plate shape and are provided so as to be parallel to the vertical direction and the second direction D2 and face each other.

In the second sidewall plate 2w, two carry-in carry-out ports ph for transporting a substrate between the inside and outside of the casing CA are formed. The two carry-in carry-out ports ph are respectively formed in two portions opposite to the liquid processing units LPA, LPB in the second direction D2 in the second sidewall plate 2w. In the top plate 6w, two openings op1 are formed to be aligned in the first direction D1. An aperture ratio of the two openings op1 in the top plate 6w is set as sufficiently large as an aperture ratio in a state where the entire upper end of the casing CA is opened upwardly.

Two filters FL are provided above the top plate 6w so as to respectively close the two openings op1 of the top plate 6w. The two filters FL may be provided immediately below the top plate 6w. In Fig. 1, the two filters FL are indicated by the thick one-dot and dash lines. The two filters FL are ULPA (Ultra-Low Penetration Air) filters, for example, and are attached to a frame (not shown) that constitutes the casing CA or the top plate 6w. An air guide AG is provided on the top plate 6w of the casing CA so as to surround the two filters FL. In Fig. 1, the air guide AG is indicated by the two-dots and dash lines.

A gas supplier 10 is provided outside of the casing CA. The gas supplier 10 is an air control unit, for example, and regulates the conditions of air such as temperature and humidity so as to satisfy a predetermined condition during power-on of the development device 1. Further, the gas supplier 10 supplies air, the conditions of which are regulated to the air guide AG through a supply air duct DU. In this case, the air guide AG guides the air supplied from the gas supplier 10 to the two openings op1 of the top plate 6w through the two filters FL. Thus, a clean air, the temperature, humidity and the like of which are regulated is supplied into the casing CA, and a downward airflow is generated in an entire internal space SP of the casing CA.

Two fluid suppliers 11 are further provided outside of the casing CA. Each fluid supplier 11 includes a development liquid supply source, a rinse liquid supply source, a gas supply source and various fluid-related elements and supplies a development liquid, a rinse liquid and gas to the liquid processing units LPA, LPB through a fluid supply path 12. In Fig. 1, the fluid supply path 12 is indicated by the one-dot and dash line. In the present embodiment, the fluid supply path 12 is constituted by one or a plurality of pipes, a valve and the like.

The development device 1 further includes a controller 90. The controller 90 includes a CPU (Central Processing Unit) and a memory, or a microcomputer, for example, and controls the liquid processing units LPA, LPB and the two fluid suppliers 11. Details of the controller 90 will be described below.

### 2. Configuration of Liquid Processing Unit

### (1) Outline of Configuration of Liquid Processing Unit

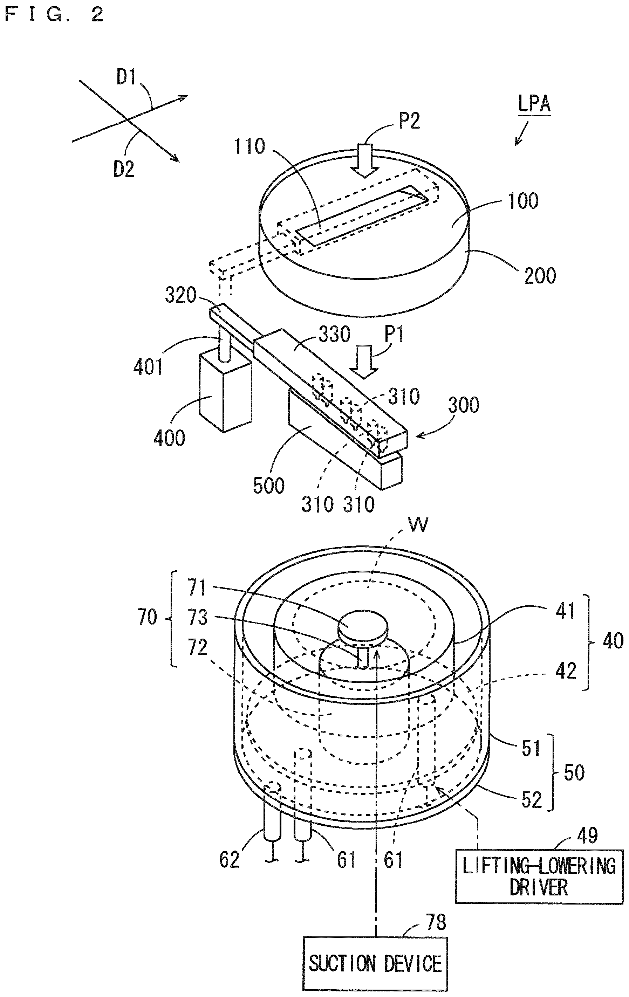

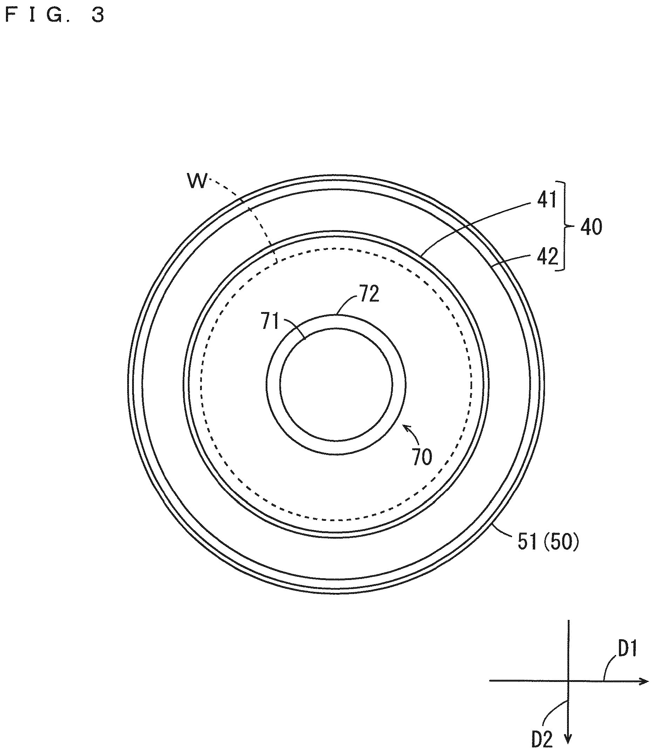

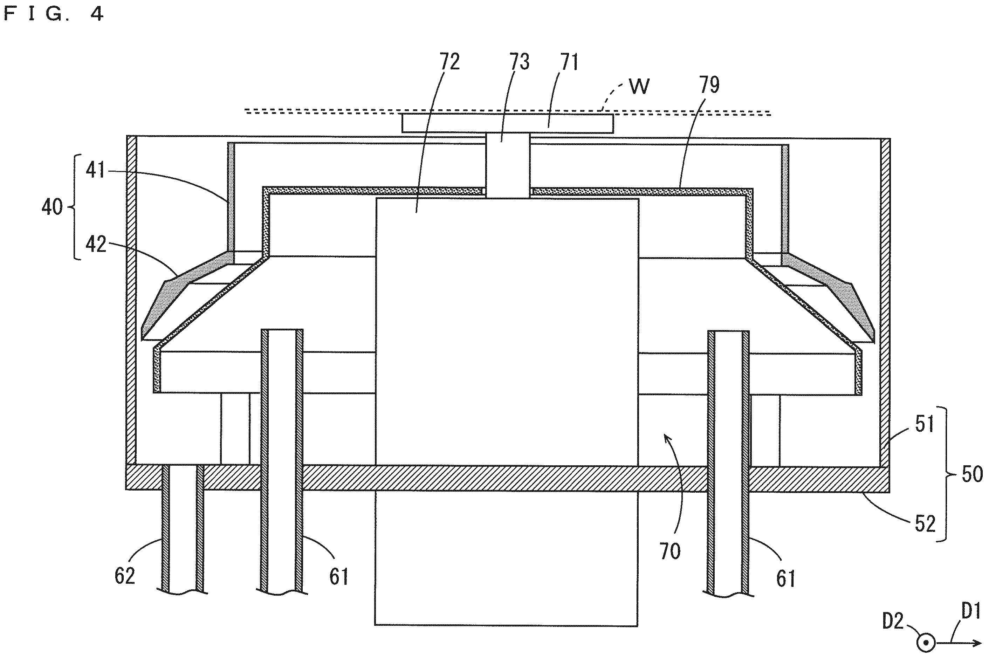

The two liquid processing units LPA, LPB of Fig. 1 basically have the same configuration except that some of constituent elements are provided to be symmetrical to each other with respect to a plane (vertical plane) orthogonal to the first direction D1. The configuration of the liquid processing unit LPA out of the two liquid processing units LPA, LPB will be described below representatively. Fig. 2 is a partially exploded perspective view for explaining the configuration of the liquid processing unit LPA of Fig. 1. Fig. 3 is a schematic plan view for explaining the configuration of a part of the liquid processing unit LPA of Fig. 2. Fig. 4 is a schematic longitudinal cross sectional view for explaining the configuration of a part of the liquid processing unit LPA of Fig. 2. In Figs. 2 to 4, a substrate W to be processed is indicated by the dotted lines.

As shown in Fig. 2, the liquid processing unit LPA includes a partition plate 100, a cylindrical member 200, a nozzle arm unit 300, a nozzle driver 400 and a waiting pod 500. Further, the liquid processing unit LPA further includes a cup 40, a lifting-lowering driver 49, a container 50, exhaust pipes 61, a drain pipe 62, a substrate holding device 70 and a suction device 78. In Fig. 2, in order to facilitate understanding of the structure of the plurality of constituent elements, some of the constituent elements are shown in the upper field, and the rest of the constituent elements are shown in the lower field.

Specifically, in Fig. 2, some of the constituent elements including the partition plate 100, the cylindrical member 200, the nozzle arm unit 300, the nozzle driver 400 and the waiting pod 500 are shown in the upper field, and the rest of the constituent elements including the cup 40, the container 50 and the substrate holding device 70 are shown in the lower field. In Figs. 3 and 4, the schematic plan view and the schematic longitudinal cross sectional view of the cup 40, the container 50 and the substrate holding device 70 are respectively shown as the partial configuration of the liquid processing unit LPA.

### (2) Cup and Container

In the casing CA of Fig. 1, the container 50 is fixed to a unit base described below. As shown in Fig. 2, the container 50 includes a sidewall portion 51 and a bottom portion 52. The sidewall portion 51 has an annular horizontal cross section, and is formed to extend in the vertical direction while having a constant inner diameter and a constant outer diameter. The bottom portion 52 is formed so as to close a lower end of the sidewall portion 51.

Three through holes are formed in the bottom portion 52. Two of the three through holes are opposite to each other with the substrate holding device 70 interposed therebetween. The exhaust pipe 61 is connected to each of the portions where these two through holes are formed. Each exhaust pipe 61 guides an atmosphere in the casing CA to an exhaust device (not shown) provided outside of the casing CA. In the container 50, an end portion (opening end) of each exhaust pipe 61 is positioned farther upwardly than the bottom portion 52.

The drain pipe 62 is further connected to the portion of the bottom portion 52 where the remaining through hole is formed. During the development processing for the substrate W, the drain pipe 62 guides the liquids (the development liquid and the rinse liquid) flowing from the cup 40 to a bottom portion of the container 50 to a drain device (not shown) provided outside of the casing CA as described below. In the container 50, an end portion (opening end) of the drain pipe 62 is positioned farther downwardly than the end portion of each exhaust pipe 61.

At least a lower portion of the substrate holding device 70 is contained in the container 50. Specifically, the substrate holding device 70 includes a suction holder 71, a spin motor 72 and a motor cover 79 (Fig. 4). In Figs. 2 and 3, the motor cover 79 is not shown. As shown in Fig. 3, the spin motor 72 is fixed onto the bottom portion 52 so as to be positioned at the center of the container 50 in a plan view. In this example, a lower portion of the spin motor 72 projects farther downwardly than the bottom portion 52. As shown in Fig. 4, a rotation shaft 73 is provided at the spin motor 72 to extend upwardly. The suction holder 71 is provided at an upper end of the rotation shaft 73. The suction holder 71 projects farther upwardly than an upper end of the container 50.

As shown in Fig. 2, the suction device 78 is provided outside of the container 50. The suction holder 71 is configured to be capable of sucking the center portion of the back surface of the substrate W by an operation of the suction device 78. The suction holder 71 sucks the center portion of the back surface of the substrate W, so that the substrate W is held in a horizontal posture at a position above the container 50. Further, the spin motor 72 operates with the substrate W held by suction by the suction holder 71, so that the substrate W is rotated in a horizontal posture.

As shown in Fig. 4, the motor cover 79 has a substantially bowl shape, and is fixed to the container 50 such that an open large-diameter portion is directed downwardly. A through hole into which the rotation shaft 73 is insertable is formed in the center portion of the upper end of the motor cover 79. With the rotation shaft 73 inserted into the through hole in the center portion of the upper end of the motor cover 79, the motor cover 79 covers an upper end portion of the spin motor 72 excluding the rotation shaft 73 and a space having a constant width and surrounding the spin motor 72 in a horizontal plane from above. A gap having a constant width is formed between an outer peripheral end of the motor cover 79 and an inner peripheral surface of the sidewall portion 51.

Here, the above-mentioned end portion of each exhaust pipe 61 is positioned below the motor cover 79. This prevents the liquids (the development liquid and the rinse liquid) dropping from above the container 50 from entering each exhaust pipe 61 during the development processing for the substrate W.

As shown in Fig. 2, at least the lower end of the cup 40 is contained in the container 50 in addition to the lower portion of the substrate holding device 70. Here, the cup 40 is configured to be movable in the vertical direction in the container 50. Further, the cup 40 includes a cylindrical wall portion 41 and a liquid receiving portion 42. Each of the cylindrical wall portion 41 and the liquid receiving portion 42 has an annular horizontal cross section and is provided to extend at least in the vertical direction. As shown in Fig. 3, the cup 40 is configured to surround the substrate holding device 70 in a plan view.

As shown in Fig. 4, an outer diameter and an inner diameter of the liquid receiving portion 42 gradually increase downwardly from the upper end of the liquid receiving portion 42. The outer diameter of the lower end of the liquid receiving portion 42 (the largest outer diameter of the liquid receiving portion 42) is smaller than an inner diameter of the sidewall portion 51 of the container 50. Therefore, a gap having a constant width is formed between an outer peripheral end of the liquid receiving portion 42 and the inner peripheral surface of the sidewall portion 51. The cylindrical wall portion 41 has a constant inner diameter and a constant outer diameter and is formed to extend upwardly from the upper end of the liquid receiving portion 42.

As shown in Fig. 2, the lifting-lowering driver 49 is provided in the vicinity of the container 50 in the casing CA of Fig. 1. The lifting-lowering driver 49 includes a driving mechanism such as a motor or an air cylinder, and changes a state of the cup 40 between a first state and a second state by supporting the cup 40 and vertically moving the cup 40. The first state and the second state of the cup 40 will be described below.

### (3) Nozzle Driver and Waiting Pod

In the casing CA of Fig. 1, the nozzle driver 400 is provided to be adjacent to the container 50 in the first direction D1. The nozzle driver 400 includes a motor having a rotation shaft 401 and an actuator. The actuator includes an air cylinder, a hydraulic cylinder, a motor or the like and supports the motor on the unit base such that the motor having the rotation shaft 401 is movable in the vertical direction. The rotation shaft 401 is positioned at the upper end of the nozzle driver 400.

In the casing CA of Fig. 1, the waiting pod 500 is further provided on the unit base. The nozzle driver 400 and the waiting pod 500 are aligned in the second direction D2 at a position lateral to the container 50 with a distance therebetween. The waiting pod 500 has a box shape extending by a certain length in the second direction D2. A plurality of waiting holes for containing injecting portions of a plurality of nozzles 310, described below, are formed in an upper surface of the waiting pod 500.

A drain pipe (not shown) that drains liquids injected or dropping from the plurality of nozzles 310 to the outside of the casing CA when the plurality of nozzles 310 are waiting is connected to the waiting pod 500. Further, an exhaust pipe (not shown) that exhausts an atmosphere in the waiting pod 500 to the outside of the casing CA is connected to the waiting pod 500.

### (4) Nozzle Arm Unit

The nozzle arm unit 300 is attached to an upper end of the rotation shaft 401. The nozzle arm unit 300 being attached to the upper end of the rotation shaft 401 has a longitudinal shape extending linearly in a direction different from the direction in which the rotation shaft 401 extends. The nozzle arm unit 300 includes a nozzle head 300H that is constituted by the plurality (six in the present example) of nozzles 310, a support 320 and a cover member 330.

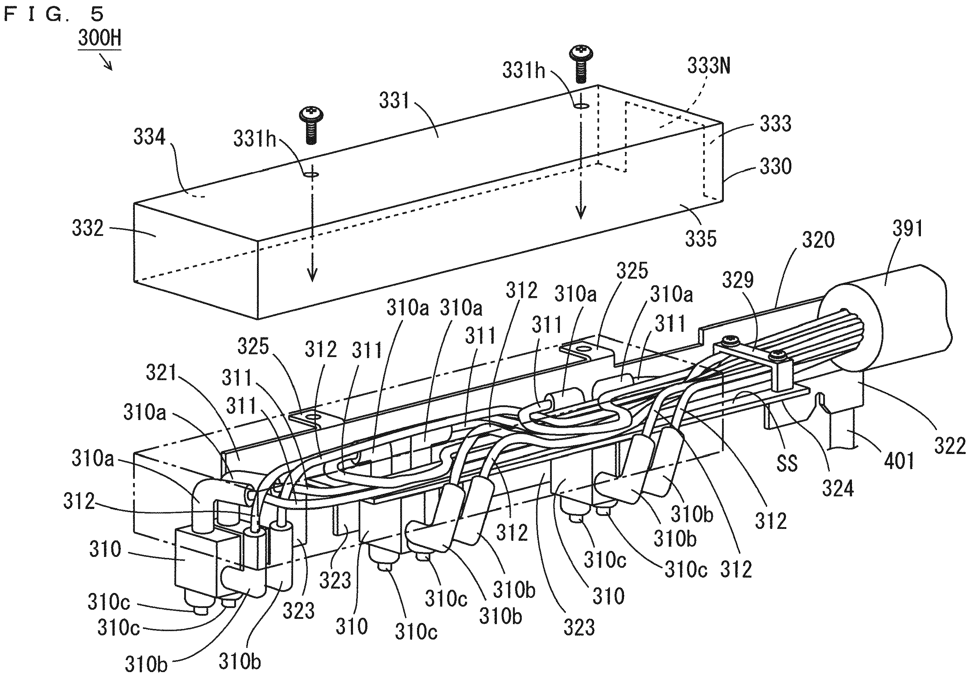

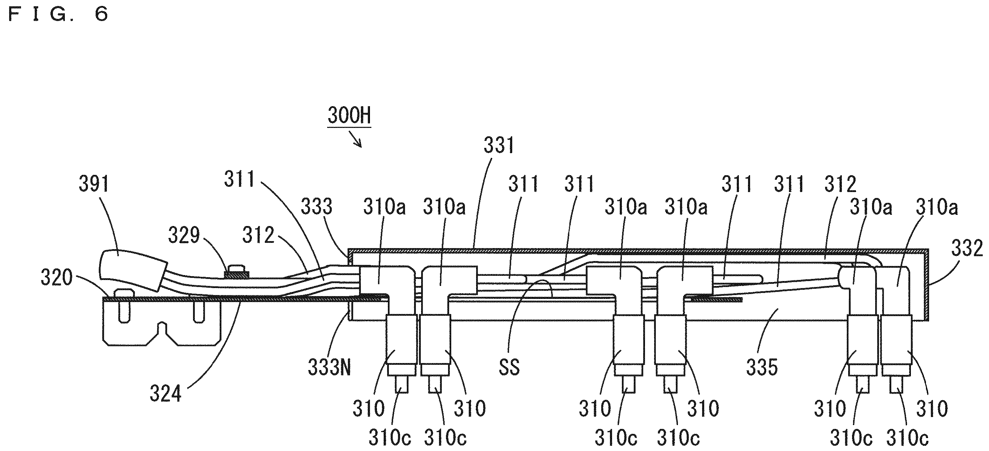

Fig. 5 is a perspective view of the nozzle arm unit 300 of Fig. 2. Fig. 6 is a longitudinal cross sectional view of the nozzle arm unit 300 taken along a predetermined vertical plane. In Fig. 5, the cover member 330 being separated from the rest of the constituent elements is shown to facilitate understanding of the internal structure of the nozzle arm unit 300.

The support 320 is fabricated by a suitable bending process of one metal plate that has been cut or laser-processed into a predetermined shape, for example. Alternatively, the support 320 is fabricated by connection of a plurality of metal plates processed into a predetermined shape by screwing, welding or the like. Also, the support 320 is formed to extend in one direction and has one end portion 321 and another end portion 322. Further, the support 320 has three nozzle fixing portions 323 which are aligned at a spacing from the vicinity of the one end portion 321 toward the other end portion 322. Two nozzles 310 are attached to each of the three nozzle fixing portions 323. Further, the support 320 includes a pipe fixing portion 324 and two cover attachment portions 325. The pipe fixing portion 324 is positioned in the vicinity of the other end portion 322. The pipe fixing portion 324 and the cover attachment portions 325 will be described below.

One of the two nozzles 310 provided at each nozzle fixing portion 323 is used to supply a development liquid to the substrate W. Also, the other one of the two nozzles 310 provided at each nozzle fixing portion 323 is used to supply a rinse liquid to the substrate W. Further, each of all of the nozzles 310 according to the present embodiment is a soft spray-type two-fluid nozzle capable of injecting a fluid mixture of liquid and gas. Therefore, each nozzle 310 has two fluid introducing portions 310a, 310b for introducing liquid and gas into the nozzle 310, and an injecting portion 310c for injecting a fluid mixture.

Each nozzle 310 is fixed to the support 320 with the injecting portion 310c directed downwardly. In this state, the fluid introducing portion 310a for introducing liquid into the nozzle 310 is provided at an upper end of each nozzle 310. Further, the fluid introducing portion 310b for introducing gas into the nozzle 310 is provided at a side portion of each nozzle 310.

One end of a pipe 311 for supplying liquid (the development liquid or the rinse liquid in the present example) to the nozzle 310 is connected to the fluid introducing portion 310a of each nozzle 310. Further, one end of a pipe 312 for supplying gas (a nitrogen gas in the present example) to the nozzle 310 is connected to the fluid introducing portion 310b of each nozzle 310. The pipes 311, 312 are formed of a flexible resin material. Examples of such a resin material are PTFE (polytetrafluoroethylene), PVC (polyvinyl chloride), PPS (polyphenylene sulfide), PFA (tetrafluoroethylene-perfluoroalkylvinylether copolymer) and the like.

The other end portion 322 of the support 320 is attached to the upper end of the rotation shaft 401 of the nozzle driver 400. In this state, a horizontal flat support surface SS is formed at a substantially center portion of the support 320 in a longitudinal direction of the support 320. A part of each of the plurality of pipes 311, 312 is provided so as to extend on the support surface SS from the nozzle 310 to which the pipe is connected toward the pipe fixing portion 324.

The pipe fixing portion 324 is constituted by a part of the support surface SS. In the pipe fixing portion 324, the plurality of pipes 311, 312 are bound. In this state, a pipe fixing piece 329 having an inverted U-shape is screwed onto the support surface SS constituting the pipe fixing portion 324. Therefore, the plurality of pipes 311, 312 are fixed in the vicinity of the other end portion 322 of the support 320. Portions of the plurality of pipes 311, 312 extending outwardly of the support 320 from the pipe fixing portion 324 and being bound are contained in a protective pipe 391. The protective pipe 391 is formed of rubber or resin, for example, and is flexible.

The cover member 330 has a box shape with an open bottom portion. Specifically, the cover member 330 of the present example includes an upper surface portion 331, one end-surface portion 332, another end-surface portion 333, one side-surface portion 334 and another side-surface portion 335. The upper surface portion 331 has a rectangular shape that is larger than a nozzle opening of the partition plate 100, described below, in a plan view. The one end-surface portion 332, the other end-surface portion 333, the one side-surface portion 334 and the other side-surface portion 335 respectively extend downwardly from the four sides of an outer edge of the upper surface portion 331. The one end-surface portion 332 and the other end-surface portion 333 face each other, and the one side-surface portion 334 and the other side-surface portion 335 face each other. A cutout 333N is formed in the other end-surface portion 333.

As described above, the support 320 has the two cover attachment portions 325. The two cover attachment portions 325 are positioned at the upper end of the support 320. A screw hole is formed in each cover attachment portion 325. In the upper surface portion 331 of the cover member 330, through holes 331h are formed in two portions corresponding to the two cover attachment portions 325 of the support 320.

With the plurality of nozzles 310 attached to the support 320, the plurality of pipes 311, 312 connected to the plurality of nozzles 310 and the plurality of pipes 311, 312 fixed, the cover member 330 is attached to the support 320. Specifically, the two through holes 331h of the cover member 330 are positioned on the two cover attachment portions 325 of the support 320, and the cover member 330 is screwed to the support 320.

Thus, a portion of the support 320 from the one end portion 321 to the vicinity of the other end portion 322 is covered by the cover member 330 from above and the side. On the other hand, the remaining portion of the support 320 is drawn out through the cutout 333N formed in the other end-surface portion 333 of the cover member 330. In this manner, a part of the support 320 is contained in the cover member 330. Further, parts of the plurality of nozzles 310 supported by the support 320 are contained in the cover member 330. Further, parts of the plurality of pipes 311, 312 supported by the support 320 are contained in the cover member 330. In Fig. 5, the cover member 330 being attached to the support 320 is indicated by the two-dots and dash lines.

Here, in the support 320, the pipe fixing portion 324 is positioned between the other end portion 322 of the support 320 and the other end-surface portion 333 of the cover member 330. The pipe fixing piece 329 binds the plurality of pipes 311, 312 and fixes them to the pipe fixing portion 324 such that the plurality of pipes 311, 312 drawn out from the cover member 330 do not come into contact with an inner edge of the cutout 333N of the other end-surface portion 333. As shown in Fig. 6, with the cover member 330 attached to the support 320, a large portion of each nozzle 310 except for the fluid introducing portion 310a projects downwardly of the cover member 330.

### (5) Partition Plate and Cylindrical Member

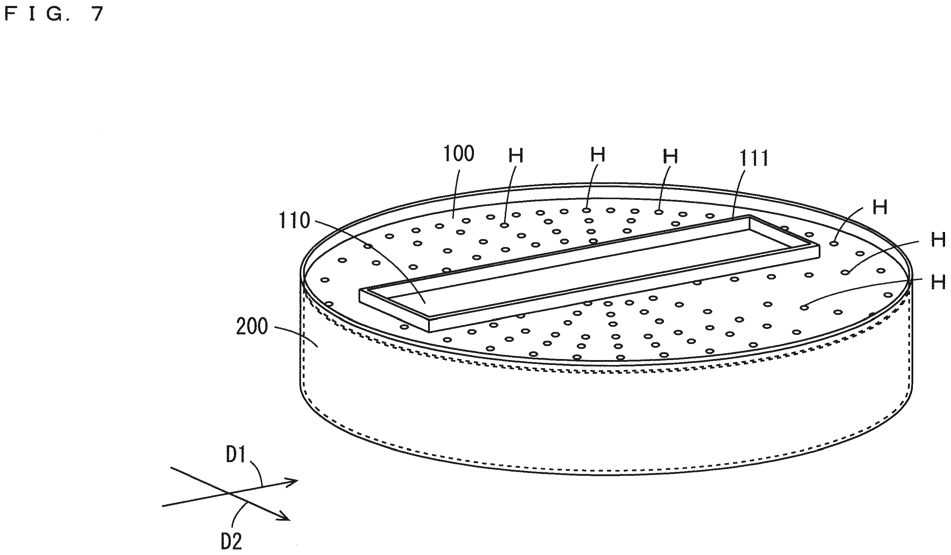

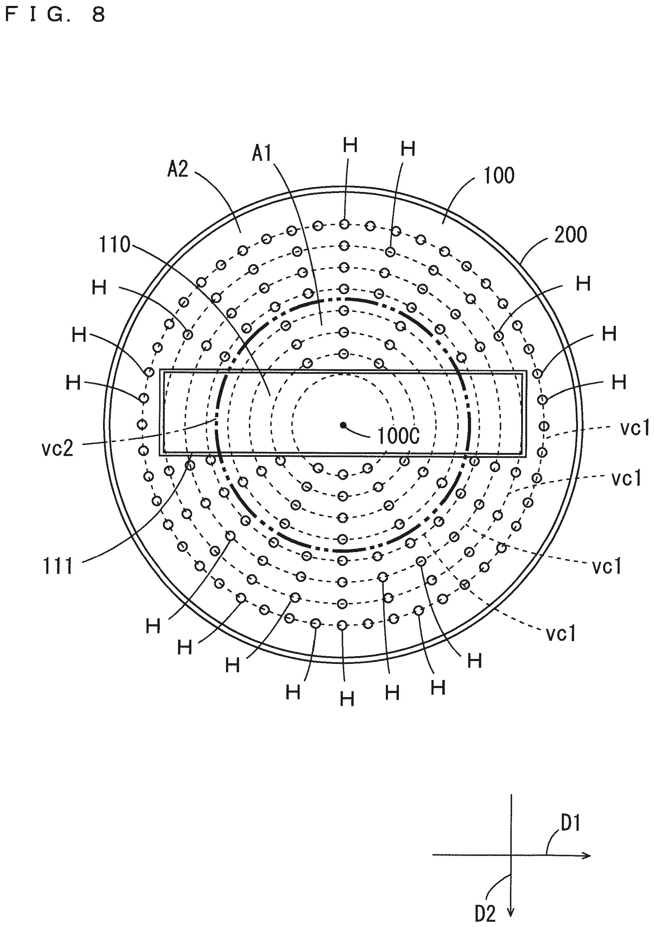

Fig. 7 is an external perspective view of the partition plate 100 and the cylindrical member 200 of Fig. 2. Fig. 8 is a plan view of the partition plate 100 and the cylindrical member 200 of Fig. 2. As shown in Figs. 7 and 8, the cylindrical member 200 has a cylindrical shape and is fixed to a part of the casing CA (Fig. 1) via a bracket (not shown). An inner diameter of the cylindrical member 200 is larger than an outer diameter of the cylindrical wall portion 41 (Fig. 3) of the cup 40. Further, the cylindrical member 200 is positioned such that the center axis of the cylindrical member 200 substantially coincides with the center axis of the cup 40 in a plan view. Thus, in a case where the cup 40 is lifted, for example, it is possible to insert the upper end of the cup 40 into the cylindrical member 200 while preventing the cup 40 from coming into contact with the cylindrical member 200.

The partition plate 100 has a substantially disc shape and is attached to the cylindrical member 200 so as to come into contact with the entire inner peripheral surface of the cylindrical member 200 in the vicinity of the upper end of the cylindrical member 200. A rectangular nozzle opening 110 extending in the first direction D1 is formed in the substantially center portion of the partition plate 100. The nozzle opening 110 is opposite to the center portion of the substrate W held by the substrate holding device 70 during the development processing for the substrate W. As shown in Fig. 7, a wall portion 111 extending upwardly from an inner edge of the nozzle opening 110 by a certain length (about 5 mm to 10 mm, for example) is formed in the portion of the partition plate 100 in which the nozzle opening 110 is formed.

As shown in Fig. 8, a plurality of through holes H are formed in the partition plate 100 so as to be dispersed over the entire partition plate 100 except for the nozzle opening 110. The number and size of the plurality of through holes H formed in the partition plate 100 are defined in consideration of the pressure relationship between a processing space and a non-processing space described below.

Specifically, in regard to the arrangement of the plurality of through holes H, as indicated by the dotted lines in Fig. 8, concentric circles (a plurality of virtual circles vc1) having a predetermined pitch are defined with respect to a partition plate center 100C in a plan view. In this case, the plurality of through holes H are dispersedly formed so as to be aligned at equal intervals on each virtual circle vc1. Further, the number of through holes H formed on the largest virtual circle vc1 among the plurality of virtual circles vc1 is larger than that of through holes H formed on each of the other virtual circles vc1. Further, in the present example, only the largest virtual circle vc1 among the plurality of virtual circles vc1 surrounds the entire nozzle opening 110. Therefore, in the largest virtual circle vc1, a plurality of through holes H are formed so as to be aligned at constant intervals over the entire virtual circle vc1.

Further, as indicated by the thick two-dots and dash line in Fig. 8, a virtual circle vc2 having a radius of 1/2 of the radius of the partition plate 100 is defined centered on the partition plate center 100C. Here, in a case where an inner region of the virtual circle vc2 is a center region A1, and an outer region of the virtual circle vc2 is an outer peripheral region A2, the number of the through holes H formed in the outer peripheral region A2 is larger than that of the through holes H formed in the center region A1.

### (6) Operation of Nozzle Arm Unit

As described above, the nozzle arm unit 300 is attached to the rotation shaft 401 of the nozzle driver 400. Therefore, when the motor of the nozzle driver 400 moves in the vertical direction, the nozzle arm unit 300 moves in the vertical direction. Further, when the motor of the nozzle driver 400 is operated, the nozzle arm unit 300 rotates in a horizontal plane around the rotation shaft 401. Thus, the plurality of nozzles 310 of the nozzle arm unit 300 are held at a waiting position P1 lateral to the substrate W held by the substrate holding device 70 in a period during which the developing processing is not performed on the substrate W. Further, the plurality of nozzles 310 are held at a processing position P2 above the substrate W held by the substrate holding device 70 in a period during which the developing processing is performed on the substrate W. In Fig. 2, the waiting position P1 and the processing position P2 are respectively indicated by the outlined arrows.

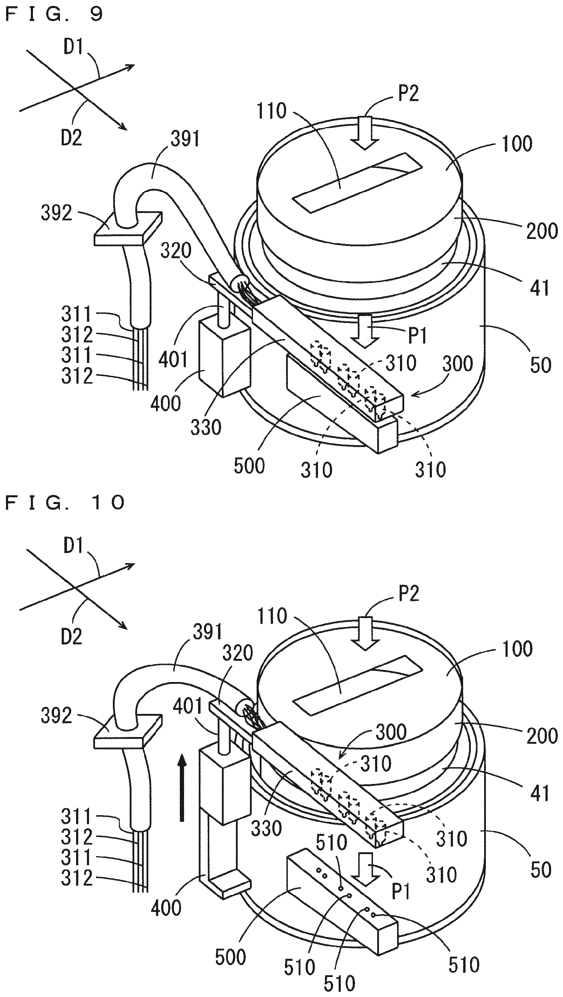

Figs. 9 to 12 are diagrams for explaining the operation of the nozzle arm unit 300 when the plurality of nozzles 310 move between the waiting position P1 and the processing position P2. In Figs. 9 to 12, the states of the nozzle arm unit 300 and its peripheral members when the plurality of nozzles 310 move from the waiting position P1 to the processing position P2 are shown in external perspective views in a chronological order. In the partition plate 100 shown in each of Figs. 9 to 12, similarly to the example of Fig. 2, the plurality of through holes H are not shown.

First, as shown in Fig. 9, with the plurality of nozzles 310 located at the waiting position P1, the nozzle arm unit 300 is located lateral to the partition plate 100 and the cylindrical member 200 and held while extending parallel to the second direction D2. At this time, the nozzle arm unit 300 is positioned such that the injecting portions 310c (Fig. 6) of the plurality of nozzles 310 are contained in a plurality of waiting holes 510 (Fig. 10) of the waiting pod 500.

When the nozzle driver 400 starts to operate in the state shown in Fig. 9, the nozzle arm unit 300 is lifted to a height position farther upward than the cylindrical member 200 together with the rotation shaft 401 as indicated by the thick solid arrow in Fig. 10. Thus, the injecting portions 310c (Fig. 6) of the plurality of nozzles 310 are drawn out from the plurality of waiting holes 510 of the waiting pod 500.

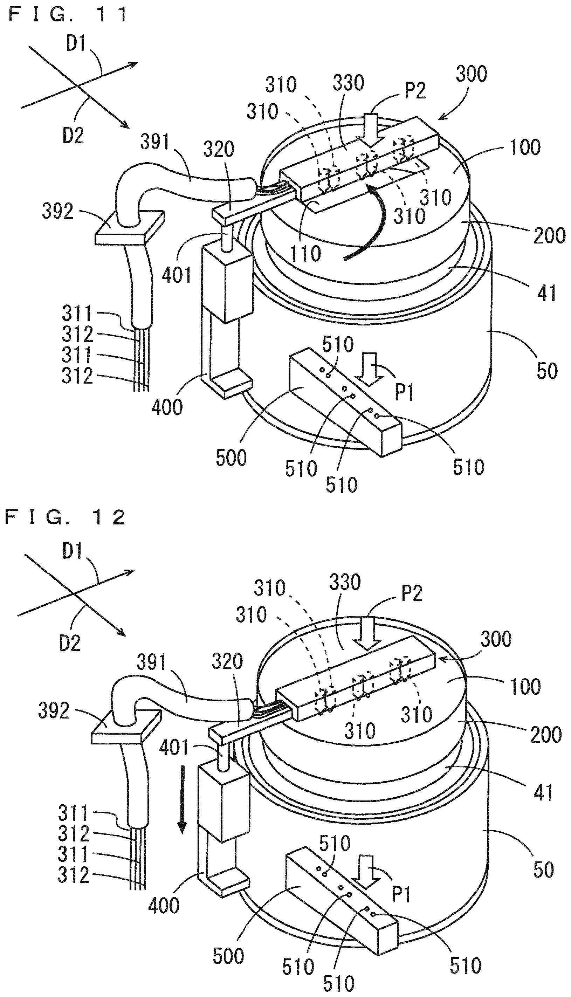

Next, the rotation shaft 401 of the nozzle driver 400 rotates by a predetermined angle (90 degrees in the present example). Thus, the nozzle arm unit 300 rotates about the rotation shaft 401 as indicated by the thick solid arrow in Fig. 11. Thus, the nozzle arm unit 300 is held while extending parallel to the first direction D1. At this time, the nozzle arm unit 300 is positioned such that the cover member 330 overlaps with the nozzle opening 110 of the partition plate 100 in a plan view.

Next, the rotation shaft 401 of the nozzle driver 400 is lowered. Thus, the cover member 330 is lowered as indicated by the thick solid arrow in Fig. 12. At this time, the height position of the nozzle arm unit 300 is adjusted such that the cover member 330 does not come into contact with the partition plate 100 and is sufficiently close to the partition plate 100. This reduces a flow of gas in the nozzle opening 110. In this manner, with the nozzle opening 110 of the partition plate 100 covered by the cover member 330, the plurality of nozzles 310 are held at the processing position P2.

### (7) Protective Pipe

Portions of the plurality of pipes 311, 312 extending outwardly from the nozzle arm unit 300 serve as movable parts that can be deformed such as being expanded and contracted, bended or twisted depending on the movement or rotation of the nozzle arm unit 300. The movable parts of the plurality of pipes 311, 312 are covered by the protective pipe 391. As shown in Figs. 9 to 12, a holder 392 for holding a part of the protective pipe 391 to a part (the unit base, for example) of the casing CA is provided in the casing CA of Fig. 1. The holder 392 fixes the part of the protective pipe 391 extending from the nozzle arm unit 300, to the casing CA.

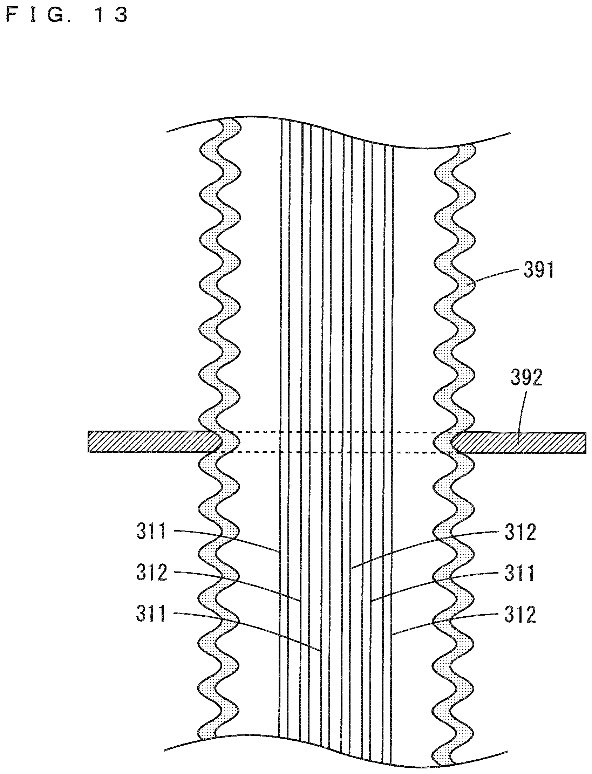

Fig. 13 is a schematic cross sectional view for explaining the configuration of the protective pipe 391. As shown in Fig. 13, the protective pipe 391 has a bellows shape. The holder 392 is a clamp, for example, and holds a valley portion of the bellows on an outer peripheral surface of the protective pipe 391. In this case, the holder 392 can hold the protective pipe 391 while keeping flexibility of the protective pipe 391.

In the present example, the nozzle arm unit 300 of Fig. 6 includes six nozzles 310, and two pipes 311, 312 are connected to each nozzle 310. Thus, twelve pipes 311, 312 are inserted into the protective pipe 391 in the present example. A gap is formed between an inner peripheral surface of the protective pipe 391 and the pipes 311, 312 in the protective pipe 391. In this case, each pipe 311, 312 can be easily deformed.

With the above-mentioned configuration, the plurality of pipes 311, 312 located between the nozzle arm unit 300 and the holder 392 are deformably bound by the protective pipe 391. Therefore, handleability of the plurality of pipes 311, 312 in the casing CA of Fig. 1 is improved. Further, since the protective pipe 391 is flexible, a degree of freedom in regard to the movement and rotation of the nozzle arm unit 300 is not limited by the protective pipe 391. The plurality of pipes 311, 312 bound by the protective pipe 391 are drawn out from the protective pipe 391 in the vicinity of the holder 392 and connected to the fluid supply path 12 of the fluid supplier 11 of Fig. 1.

In some cases, the movable parts of the pipes 311, 312 are damaged by deformation or rubbing that repetitively occurs. However, even in a case where leakage of liquid occurs at a damaged part of any of the pipes 311, since the pipe 311 is covered by the protective pipe 391, the leak liquid is received by the inner peripheral surface of the protective pipe 391 and is guided downwardly by gravity. This prevents scattering of the leak liquid. The leak liquid guided downwardly is discharged from a lower end of the protective pipe 391 and detected by a leak sensor. Details of this configuration will be described below.

In the present example, the protective pipe 391 is formed of polyamide. In this case, the protective pipe 391 has a high chemical resistance. Thus, even in a case where a liquid such as a development liquid or a rinse liquid adheres to the protective pipe 391, the protective pipe 391 is prevented from being corroded. The protective pipe 391 may be formed of another rubber or resin as far as the protective pipe 391 has a chemical resistance.

### (8) Unit Base

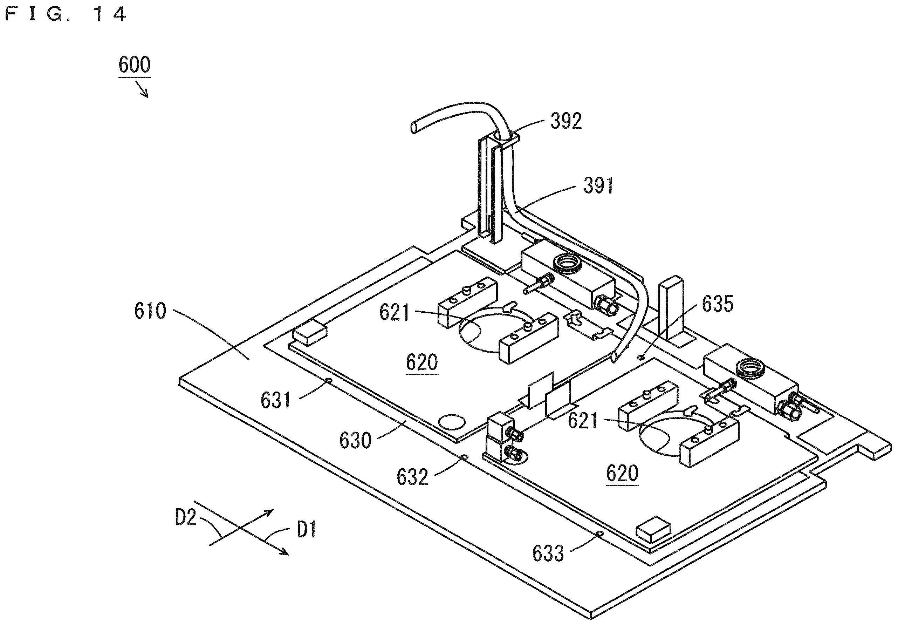

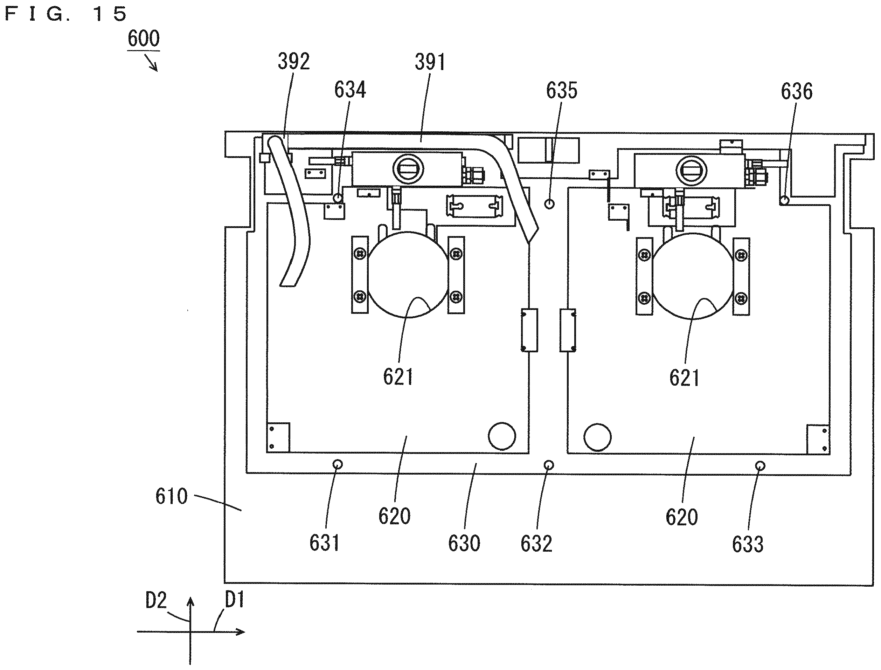

Fig. 14 is a perspective view of a unit base. Fig. 15 is a plan view of the unit base of Fig. 14. As shown in Figs. 14 and 15, the unit base 600 includes a base plate 610 having a substantially rectangular shape. Two unit arrangement regions 620 are provided to be aligned in the first direction D1 in a substantially center portion of the base plate 610. The liquid processing units LPA, LPB of Fig. 1 are respectively arranged in the two unit arrangement regions 620.

As described above, in each liquid processing unit LPA, LPB, a lower portion of the spin motor 72 projects farther downwardly than the bottom portion 52 of the container 50 (Fig. 4). As such, a circular opening 621 is formed in each unit arrangement region 620. When each liquid processing unit LPA, LPB is arranged in the corresponding unit arrangement region 620, the lower portion of the spin motor 72 is contained in the opening 621. This prevents the spin motor 72 and the base plate 610 from interfering with each other.

An exhaust air duct connected to the exhaust pipe 61 of Fig. 4 is provided in each unit arrangement region 620. An exhaust air from the exhaust pipe 61 is guided to the exhaust device (not shown) through this exhaust air duct. A conduit connected to the drain pipe 62 of Fig. 4 is provided in each unit arrangement region 620. A waste liquid from the drain pipe 62 is guided to the drain device (not shown) through this conduit.

A holder 392 corresponding to the liquid processing unit LPA is provided in the vicinity of one corner of the base plate 610. A holder 392 corresponding to the liquid processing unit LPB is provided in the vicinity of another corner of the base plate 610. In Figs. 14 and 15, only the holder 392 corresponding to the liquid processing unit LPB is shown, and the holder 392 corresponding to the liquid processing unit LPA is not shown. Further, only the protective pipe 391 held by the one holder 392 is shown, and the plurality of pipes 311, 312 (Fig. 13) bound by the protective pipe 391 are not shown.

A groove 630 is formed around and between the two unit arrangement regions 620 on the base plate 610. A lower end of the protective pipe 391 held by each holder 392 is contained in the groove 630. Downstream portions of the plurality of pipes 311, 312 bound by the protective pipe 391 are connected to the plurality of nozzles 310 of Fig. 6. Upstream portions of the plurality of pipes 311, 312 are drawn out from the protective pipe 391 and connected to the fluid supply path 12 of the fluid supplier 11 of Fig. 1 while being contained in the groove 630.

A plurality of (six in this example) drain holes 631 to 636 vertically penetrating the base plate 610 are formed in the groove 630. The drain hole 631 and the drain hole 634 are arranged to be aligned in the second direction D2 with the one unit arrangement region 620 interposed therebetween. The drain hole 633 and the drain hole 636 are arranged to be aligned in the second direction D2 with the other unit arrangement region 620 interposed therebetween. The drain hole 632 is arranged at a substantially intermediate position between the drain hole 631 and the drain hole 633 in the first direction D1. The drain hole 635 is arranged at a substantially intermediate position between the drain hole 634 and the drain hole 636 in the first direction D1.

With the above-mentioned configuration, even in a case where leakage of liquid occurs due to the damage of the movable parts of the pipes 311 covered by the protective pipe 391, the leak liquid is discharged from the protective pipe 391 and is guided into the groove 630. The leak liquid guided into the groove 630 drops through any of the drain holes 631 to 636. Here, the leak liquid that has dropped from any of the drain holes 631 to 636 is received by a vat described below.

### (9) Vat

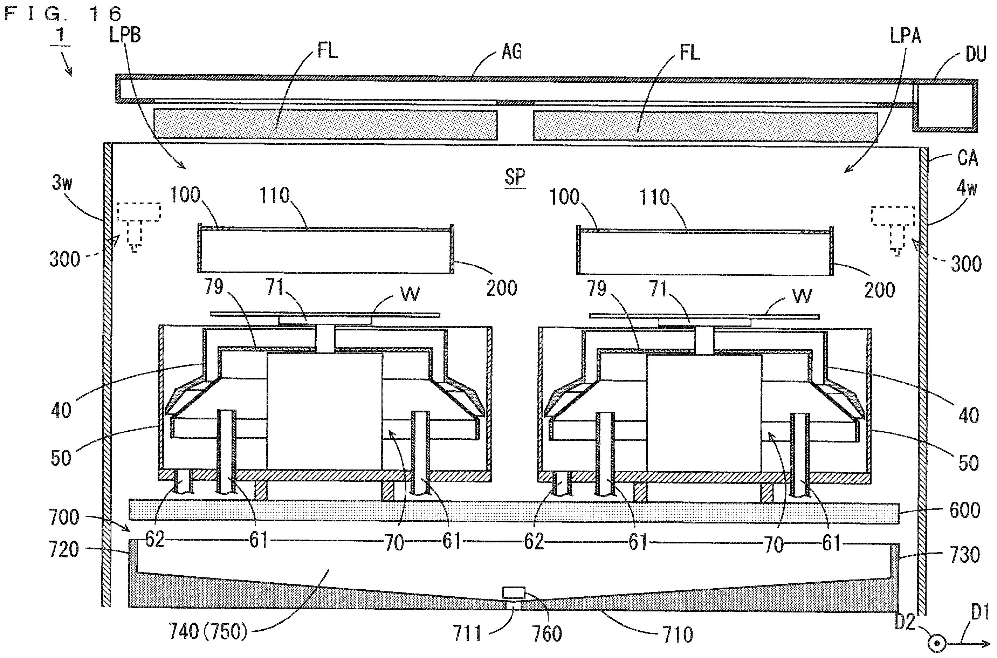

Fig. 16 is a schematic cross sectional view of the development device 1. As shown in Fig. 16, a vat 700 is arranged below the unit base 600 in the casing CA. The vat 700 has a box shape with its top portion open. Specifically, the vat 700 includes a lower surface portion 710, one end-surface portion 720, another end-surface portion 730, one side-surface portion 740 and another side-surface portion 750.

The lower surface portion 710 has a rectangular shape of a substantially same size as that of the base plate 610 (Fig. 16) of the unit base 600 in a plan view. The one end-surface portion 720, the other end-surface portion 730, the one side-surface portion 740 and the other side-surface portion 750 respectively extend upwardly from the four sides of an outer edge of the lower surface portion 710. The one end-surface portion 720 and the other end-surface portion 730 face each other, and the one side-surface portion 740 and the other side-surface portion 750 face each other.

An upper surface of the lower surface portion 710 is formed in a tapered shape. Thus, a lowest portion is provided on the upper surface of the lower surface portion 710. A through hole 711 is formed in the lowest portion of the upper surface of the lower surface portion 710. The through hole 711 is connected to the drain device. A leak sensor 760 is arranged in the vicinity of the through hole 711.

In the present example, the height of the upper surface of the lower surface portion 710 gradually increases outwardly from the center portion of the upper surface. Thus, the center portion of the upper surface of the lower surface portion 710 is the lowest portion, and the leak sensor 760 is arranged at the center portion of the lower surface portion 710. However, the embodiment is not limited to this. The lowest portion of the upper surface of the lower surface portion 710 may be provided at a position different from the center portion.

With the above-mentioned configuration, the leak liquid that has dropped from any of the drain holes 631 to 636 of the unit base 600 of Fig. 15 is received by the lower surface portion 710 of the vat 700. The received leak liquid is guided to the lowest portion along the inclined upper surface of the lower surface portion 710 and discharged from the through hole 711 to the drain device. Also, the leak liquid received by the lower surface portion 710 comes into contact with the leak sensor 760 in the vicinity of the through hole 711, so that it is detected that leakage of liquid has occurred. This makes it possible to take appropriate measures such as stopping the development device 1.

### (10) Operation of Cup

In the development device 1, each cup 40 is kept in a first state when the substrate W is carried into or carried out from the liquid processing unit LPA, LPB. On the other hand, during the development processing for the substrate W held by the substrate holding device 70, the cup 40 is kept in a second state. The first state and the second state of the cup 40 will be described.

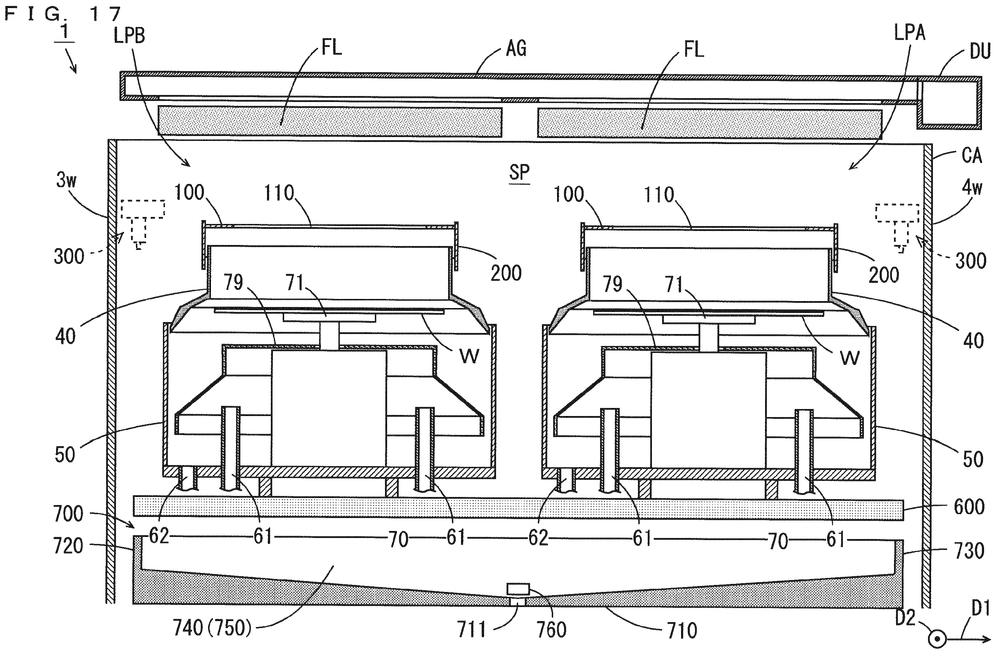

Fig. 17 is a schematic longitudinal cross sectional view of the development device 1 when the cup 40 of each of the liquid processing units LPA, LPB is in the second state. Fig. 16 is a schematic longitudinal cross sectional view of the development device 1 when the cup 40 of each of the liquid processing units LPA, LPB is in the first state. In Figs. 16 and 17, each nozzle arm unit 300 located at the waiting position P1 is indicated by the dotted lines. Also, in Figs. 16 and 17, some of the plurality of constituent elements of the liquid processing units LPA, LPB are not shown.

As shown in Fig. 16, when each cup 40 is in the first state, the cup 40 is located in each container 50. That is, when the cup 40 is in the first state, the cup 40 overlaps with the container 50 in a side view and is spaced apart from the cylindrical member 200. Therefore, when the cup 40 is in the first state, each substrate holding device 70 can be accessed from the side of the cup 40 and the container 50. Thus, the substrate W carried in from the outside of the development device 1 can be placed on the suction holder 71 of each liquid processing unit LPA, LPB. Further, the substrate W placed on the suction holder 71 of each liquid processing unit LPA, LPB can be taken out and carried out from the development device 1.

The height (dimension in the vertical direction) of the cup 40 is set larger than the distance between the cylindrical member 200 and the container 50 in the vertical direction. As shown in Fig. 17, when the cup 40 is in the second state, the cup 40 overlaps with the lower end of the cylindrical member 200 and the upper end of the container 50 in a side view. At this time, the upper end of the cup 40 and an inner peripheral surface in the vicinity of the lower end of the cylindrical member 200 are close to each other. Further, the lower end of the cup 40 and the inner peripheral surface in the vicinity of the upper end of the container 50 are close to each other.

### (11) Processing Space and Non-processing Space

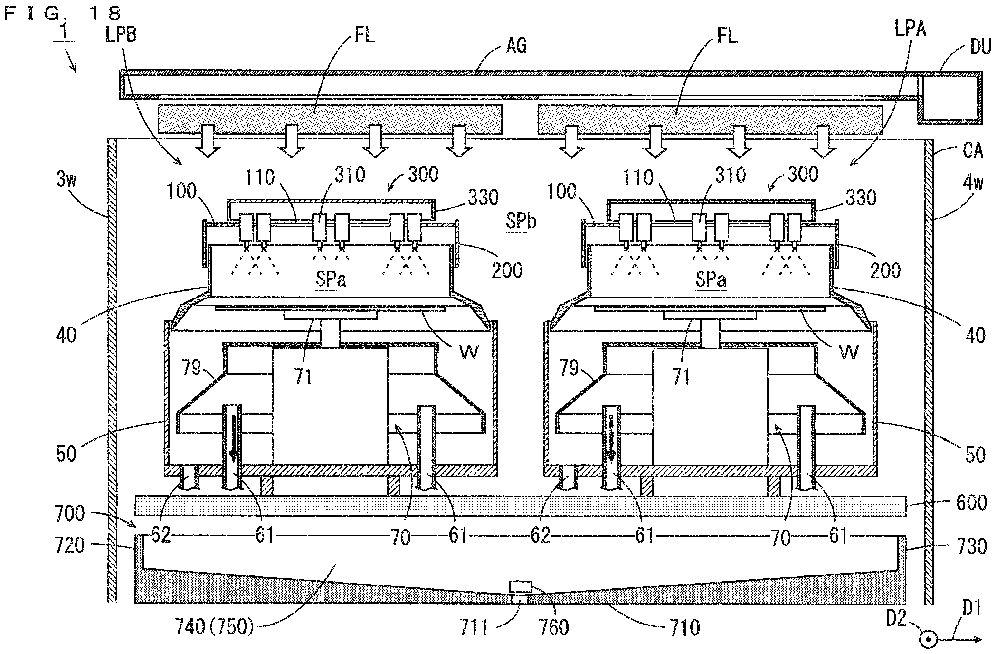

During the development processing for the substrate W, the cup 40 is held in the second state, and the plurality of nozzles 310 of the nozzle arm unit 300 are arranged at the processing position P2. Fig. 18 is a schematic longitudinal cross-sectional view of the development device 1 during the development processing for the substrate W. As shown in Fig. 18, during the developing processing for the substrate W, in each of the liquid processing units LPA, LPB, the plurality of nozzles 310 are arranged at the processing position P2 (Fig. 12), and the cover member 330 covers the nozzle opening 110 of the partition plate 100. Thus, the internal space SP of the casing CA is partitioned into processing spaces SPa and a non-processing space SPb by the partition plates 100, the cylindrical members 200, the cover members 330, the cups 40 and the containers 50 of the liquid processing units LPA, LPB. Each processing space SPa is a space including the substrate W held by each substrate holding device 70, and the non-processing space SPb is a space surrounding the processing spaces SPa.

As indicated by the outlined arrows in Fig. 18, clean air is continuously supplied to the non-processing space SPb from above. Further, part of the clean air supplied to the non-processing space SPb is supplied to the processing spaces SPa through the plurality of through holes H (Fig. 8) of the partition plates 100. Thus, in the casing CA, a downward flow of clean air is formed in each of the two processing spaces SPa and the non-processing space SPb.

An inner peripheral surface of the liquid receiving portion 42 of the cup 40 forming each processing space SPa surrounds the substrate W held by the substrate holding device 70 in a horizontal plane. Thus, large portions of the development liquid and the rinse liquid supplied to the substrate W from the plurality of nozzles 310 during the development processing for the substrate W are received by the inner peripheral surface of the liquid receiving portion 42 and guided to the container 50. On the other hand, splashes of the development liquid or the rinse liquid that are not received by the liquid receiving portion 42 but splash around the substrate W are guided to the container 50 by a downward airflow formed in the processing space SPa.

When the substrate W is rotated by the substrate holding device 70 in the processing space SPa, an airflow (upward airflow) directed from below toward above is generated along the inner peripheral surfaces of the cup 40 and the cylindrical member 200 in the vicinity of the peripheral edge of the substrate W in some cases. In such cases, when an atmosphere including the splashes of the development liquid or the rinse liquid is lifted in the processing space SPa, these splashes may adhere to the lower surface of the partition plate 100 and the inner peripheral surface of the cylindrical member 200. Further, these splashes may re-adhere to the substrate W.

As such, as described with reference to Fig. 8, in a case where concentric circles are defined on the substrate W, the partition plate 100 is fabricated such that the number of through holes H formed on the largest virtual circle vc1 is larger than that of through holes H formed on each of the other virtual circles vc1. Further, the partition plate 100 is fabricated such that the plurality of through holes H are dispersedly arranged at constant intervals over the entire largest virtual circle vc1 surrounding the nozzle opening 110. Alternatively, in a case where the center region A1 and the outer peripheral region A2 are defined on the partition plate 100, the partition plate 100 is fabricated such that the number of through holes H formed in the outer peripheral region A2 is larger than that of through holes H formed in the center region A1.

With the above-mentioned configuration of the partition plate 100, in the processing space SPa, an amount of a downward airflow guided to the vicinity of the inner peripheral surface of the cup 40 can be made larger than that of a downward airflow guided to the center portion of the substrate W. In particular, in a case where the plurality of through holes H are dispersedly arranged at constant intervals over the entire largest virtual circle vc1 surrounding the nozzle opening 110, a downward airflow can be formed in the vicinity of the inner peripheral surface of the cup 40 over the entire circumference of the inner peripheral surface of the cup 40. This suppresses generation of an upward airflow in the vicinity of the inner peripheral surface of the cup 40 during rotation of the substrate W. Therefore, in the processing space SPa, upward splashing of the development liquid or the rinse liquid supplied to the substrate W in the vicinity of the outer peripheral end of the substrate W is suppressed. As a result, adherence of the splashes of the development liquid or the rinse liquid to the lower surface of the partition plate 100 and the inner peripheral surface of the cylindrical member 200 is suppressed. Further, re-adherence of the development liquid or the rinse liquid to the substrate W is suppressed.

### 3. Configuration of Controller of Development Device

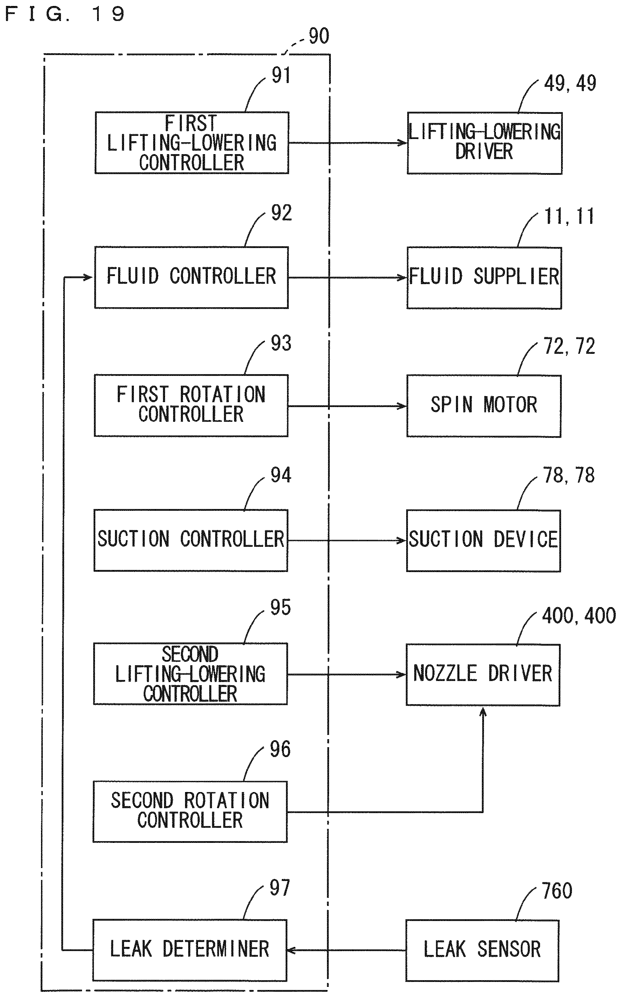

Fig. 19 is a block diagram showing the configuration of the controller 90 of the development device 1 of Fig. 1. As shown in Fig. 19, the controller 90 includes a first lifting-lowering controller 91, a fluid controller 92, a first rotation controller 93, a suction controller 94, a second lifting-lowering controller 95, a second rotation controller 96, and a leak determiner 97. The function of each element of the controller 90 of Fig. 19 is implemented by execution of a predetermined program stored in the memory by the CPU, for example.

The first lifting-lowering controller 91 controls the operation of the lifting-lowering driver 49 of each of the liquid processing units LPA, LPB. Thus, the state of the cup 40 of each of the liquid processing units LPA, LPB changes to the first state or the second state. The fluid controller 92 controls the operation of the two fluid suppliers 11 of Fig. 1. Thus, in each of the liquid processing units LPA, LPB, a fluid mixture of a development liquid and gas is injected from some of the plurality of nozzles 310, and a fluid mixture of a rinse liquid and gas is injected from the rest of the nozzles 310. The fluid controller 92 also controls the operation of the fluid suppliers 11 such that the supply of fluid is stopped in a case where a leak signal, described below, is applied from the leak determiner 97.

The first rotation controller 93 controls the operation of the spin motors 72 of the liquid processing units LPA, LPB of Fig. 1. Further, the suction controller 94 controls the operation of the suction devices 78 of the liquid processing units LPA, LPB of Fig. 1. Thus, in each substrate holding device 70, the substrate W is held by suction and rotated in a horizontal posture.

The second lifting-lowering controller 95 and the second rotation controller 96 control the operation of the nozzle drivers 400 of the liquid processing units LPA, LPB of Fig. 1. Specifically, the second lifting-lowering controller 95 controls the operation of the actuator of each nozzle driver 400. The second rotation controller 96 controls the operation of the motor having the rotation shaft 401 of each nozzle driver 400. The leak determiner 97 determines whether a leak liquid is detected by the leak sensor 760. In a case where it is determined that the leak liquid is detected, the leak determiner 97 applies a leak signal indicating that the leakage of liquid is detected to the fluid controller 92.

### 4. Basic Operation of Development Device

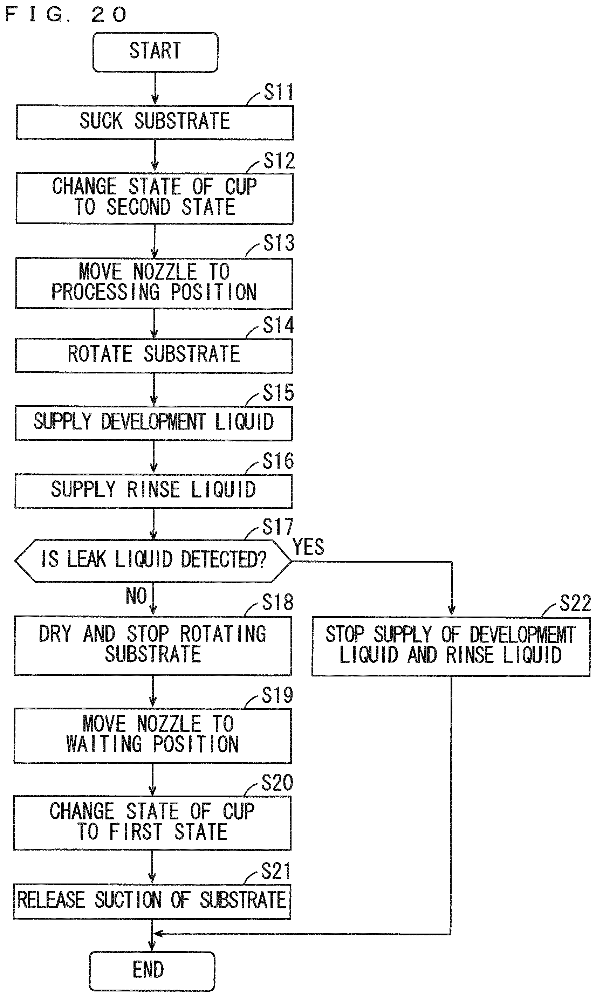

A basic operation of the development device 1 will be described. Fig. 20 is a flowchart showing the basic operation during the development processing for the substrate W by the development device 1. In an initial state, air whose temperature, humidity and the like are adjusted is supplied from the gas supplier 10 to the development device 1. Also, an atmosphere in the casing CA is guided to the exhaust device (not shown) from the exhaust pipes 61 of the liquid processing units LPA, LPB. A downward flow of clean air is formed in the casing CA. Further, in the initial state, the cup 40 is held in the first state. Also, the plurality of nozzles 310 are held at the waiting position P1.

Before the development processing for the substrate W is started, the substrate W to be processed is first carried into each of the liquid processing units LPA, LPB. Further, as shown in Fig. 16, the substrate W is placed on the suction holder 71 of the substrate holding device 70. When the development processing for the substrate W is started, the suction controller 94 of Fig. 19 controls the suction device 78 of the liquid processing unit LPA, LPB such that the substrate W is sucked by the suction holder 71 of the substrate holding device 70 (step S11).

Next, the first lifting-lowering controller 91 of Fig. 19 controls the lifting-lowering driver 49 of the liquid processing unit LPA, LPB such that the state of the cup 40 changes from the first state to the second state (step S12).

Then, the second lifting-lowering controller 95 and the second rotation controller 96 of Fig. 19 control the nozzle driver 400 of the liquid processing unit LPA, LPB such that the plurality of nozzles 310 move from the waiting position P1 to the processing position P2 (step S13).

Then, the first rotation controller 93 of Fig. 19 controls the spin motor 72 of the liquid processing unit LPA, LPB such that the substrate W rotates about the rotation shaft 73 (step S14).

Next, the fluid controller 92 of Fig. 19 controls the fluid supplier 11 of the liquid processing unit LPA, LPB such that a development liquid is supplied to the substrate W from some of the plurality of nozzles 310 for a predetermined period of time (step S15). Further, the fluid controller 92 of Fig. 19 controls the fluid supplier 11 of the liquid processing unit LPA, LPB such that a rinse liquid is supplied to the substrate W from the rest of the plurality of nozzles 310 for a predetermined period of time (step S16).

In a case where any damage occurs in the plurality of pipes 311, the leak sensor 760 detects a leak liquid. Thus, the leak determiner 97 of Fig. 19 determines whether the leak liquid is detected by the leak sensor 760 (step S17). Step S17 may be performed in parallel and simultaneously with step S15, step S16.

In a case where no leak liquid is detected, the first rotation controller 93 of Fig. 19 dries the substrate W by continuing to rotate the substrate W until a certain period of time elapses from the time when supply of the rinse liquid is stopped. Further, the first rotation controller 93 of Fig. 19 controls the spin motor 72 of the liquid processing unit LPA, LPB such that the rotation of the substrate W is stopped after the certain period of time elapses from the time when the supply of the rinse liquid is stopped (step S18).

Then, the second lifting-lowering controller 95 and the second rotation controller 96 of Fig. 19 control the nozzle driver 400 of the liquid processing unit LPA, LPB such that the plurality of nozzles 310 move from the processing position P2 to the waiting position P1 (step S19).

Then, the first lifting-lowering controller 91 of Fig. 19 controls the lifting-lowering driver 49 of the liquid processing unit LPA, LPB such that the state of the cup 40 changes from the second state to the first state (step S20).

Finally, the suction controller 94 of Fig. 19 controls the suction device 78 of the liquid processing unit LPA, LPB such that suction of the substrate W by the suction holder 71 of the substrate holding device 70 is released (step S21). Thus, the development processing for the substrate W is ended. The substrate W on which the development processing has been performed is carried out from the liquid processing unit LPA, LPB.

On the other hand, in a case where the leak liquid is detected in step S17, the leak determiner 97 of Fig. 19 applies a leak signal to the fluid controller 92. Thus, the fluid controller 92 controls the fluid supplier 11 of the liquid processing unit LPA, LPB such that the supply of the development liquid and the rinse liquid is stopped (step S22). After that, the development processing is ended.

In a case where the leak liquid is detected in step S17, the leak determiner 97 may notify the user of the development device 1 that the leakage of liquid has occurred. As an example of the notification by the leak determiner 97, in a case where the development device 1 includes a display device, a character string indicating that any abnormality has occurred may be displayed. In a case where the development device 1 includes an audio output device, an audio similarly indicating that any abnormality has occurred may be output, or a warning sound such as a buzzer sound may be output. In a case where the development device 1 includes an indication light such as a lamp, the indication light may be turned on, turned off or blinked in a manner corresponding to the contents of a warning.

In a case where the above-mentioned notification is performed, the user of the development device 1 can recognize that the leakage of liquid has occurred, and can make an appropriate response. As such, step S22 does not need to be performed.

### 5. Effects

In the development device 1 according to the present embodiment, the nozzle head 300H is moved from the waiting position P1 to the processing position P2 by the nozzle driver 400. In this state, the processing liquid and the gas are discharged from the plurality of nozzles 310 of the nozzle head 300H to the substrate W through the plurality of pipes 311, 312. In this case, the substrate W can be processed in a short period by the plurality of nozzles 310.

Here, the pipes 311, 312 are deformed by the movement of the nozzle head 300H. When the pipes 311, 312 are repetitively deformed, the pipes 311, 312 are damaged, so that leakage of liquid occurs in some cases. As such, the outer periphery of the pipes 311, 312 is surrounded by the protective pipe 391.

With this configuration, even in a case where any of the pipes 311, 312 are damaged, the leak liquid is received by the inner peripheral surface of the protective pipe 391. This prevents scattering of the leak liquid. Also, since the leak liquid from the pipes 311, 312 is detected by the leak sensor 760, appropriate measures can be taken. As a result, an adverse effect caused by the leakage of liquid can be prevented.

Specifically, the unit base 600 having the groove 630 is arranged below the protective pipe 391. The drain hole 631 vertically penetrating the unit base 600 is formed in the groove 630. The leak liquid from the pipes 311, 312 that has passed through the drain hole 631 is detected by the leak sensor 760. In this case, the leak liquid from the pipes 311, 312 can be detected with the simple configuration.

In the present example, a part of the pipes 311, 312 is contained in the groove 630 of the unit base 600. As such, the leak liquid from the pipes 311, 312 spills down the pipes 311, 312, is guided into the groove 630, and then passes through the drain hole 631. Thus, the leak liquid from the pipes 311, 312 can be more reliably detected.

Also, the vat 700 is arranged below the unit base 600. The leak liquid that has passed through the drain hole 631 of the unit base 600 is received by the vat 700. The leak sensor 760 is provided in the vat 700. Thus, the leak liquid from the pipes 311, 312 can be easily detected in the vat 700. In particular, since the vat 700 has a tapered shape and the leak sensor 760 is provided at the lowest position in the tapered portion of the vat 700, the leak liquid from the pipes 311, 312 can be more reliably detected.

The protective pipe 391 has the bellows shape. In this case, since the protective pipe 391 is flexible, the degree of freedom in deformation of the pipes 311, 312 is not limited by the protective pipe 391. Thus, the nozzle head 300H can be more smoothly moved. Also, the valley portion of the bellows of the protective pipe 391 is held by the holder 392. In this case, it is possible to easily hold the protective pipe 391 while keeping the flexibility of the protective pipe 391.

### 6. Other Embodiments

(1) While the nozzle arm unit 300 includes the plurality of nozzles 310 in the above-mentioned embodiment, the embodiment is not limited to this. The nozzle arm unit 300 may include one nozzle 310. In this case, the one nozzle 310 may be configured to be movable by the nozzle driver 400. While the pipes 311, 312 are connected to the nozzle 310, the embodiment is not limited to this. Only the pipe 311 may be connected to the nozzle 310. That is, only one pipe 311 may be provided in the nozzle arm unit 300.
(2) While the protective pipe 391 has the bellows shape in the above-mentioned embodiment, the embodiment is not limited to this. The protective pipe 391 should be flexible, but does not need to have the bellows shape. Therefore, the holder 392 may hold any portion of the protective pipe 391.
(3) While the vat 700 has the tapered shape and the leak sensor 760 is provided at the lowest position in the tapered portion of the vat 700 in the above-mentioned embodiment, the embodiment is not limited to this. As far as the leak sensor 760 can detect the leak liquid, the leak sensor 760 may be provided at a position different from the lowest position in the tapered portion of the vat 700. Also, the vat 700 does not need to have a tapered shape. Alternatively, the development device 1 does not need to include the vat 700.
(4) While the lower end of the protective pipe 391 and the upstream portions of the pipes 311, 312 are contained in the groove 630 of the unit base 600 in the above-mentioned embodiment, the embodiment is not limited to this. As far as the leak sensor 760 can detect the leak liquid, the lower end of the protective pipe 391 and the upstream portions of the pipes 311, 312 do not need to be contained in the groove 630 of the unit base 600. Alternatively, the development device 1 does not need to include the unit base 600.

### 7. Correspondences Between Constituent Elements in Claims and Parts in Preferred Embodiments

In the following paragraphs, non-limiting examples of correspondences between various elements recited in the claims below and those described above with respect to various preferred embodiments of the present invention are explained. As each of various elements recited in the claims, various other elements having configurations or functions described in the claims can be also used.

In the above-mentioned embodiment, the substrate W is an example of a substrate, the nozzle 310 is an example of a nozzle, the pipe 311, 312 is an example of a pipe, and the protective pipe 391 is an example of a protective pipe. The nozzle driver 400 is an example of a nozzle driver, the leak sensor 760 is an example of a leak sensor, the development device 1 is an example of a substrate processing apparatus, and the groove 630 is an example of a groove. The unit base 600 is an example of a unit base, the drain hole 631 is an example of a drain hole, the vat 700 is an example of a vat, the holder 392 is an example of a holder, and the nozzle head 300H is an example of a nozzle head.

### 8. Overview of Embodiments

(Item 1) A substrate processing apparatus according to item 1 includes
a nozzle that discharges a processing liquid to a substrate to be processed,
a pipe connected to the nozzle,
a protective pipe that surrounds an outer periphery of the pipe,
a nozzle driver that moves the nozzle, and
a leak sensor that detects a leak liquid from the pipe.

In this substrate processing apparatus, the nozzle is moved by the nozzle driver, and the processing liquid is discharged from the nozzle to the substrate to be processed through the pipe. Here, the pipe is deformed by the movement of the nozzle. When the pipe is repetitively deformed, the pipe is damaged, so that leakage of liquid occurs in some cases. As such, the outer periphery of the pipe is surrounded by the protective pipe.

With this configuration, even in a case where the pipe is damaged, the leak liquid is received by an inner peripheral surface of the protective pipe. This prevents scattering of the leak liquid. Also, since the leak liquid from the pipe is detected by the leak sensor, appropriate measures can be taken. As a result, an adverse effect caused by the leakage of liquid can be prevented.

(Item 2) The substrate processing apparatus according to item 1 may further include
a unit base that has a groove and is arranged below the protective pipe,
a drain hole that vertically penetrates the unit base may be formed in the groove, and
the leak sensor may detect the leak liquid from the pipe that has passed through the drain hole.

In this case, the leak liquid from the pipe can be detected with a simple configuration.

(Item 3) In the substrate processing apparatus according to item 2,
a part of the pipe may be contained in the groove of the unit base.

In this case, the leak liquid from the pipe spills down the pipe, is guided into the groove and then passes through the drain hole. Thus, the leak liquid from the pipe can be more reliably detected.

(Item 4) The substrate processing apparatus according to item 2 or 3 may further include
a vat that is arranged below the unit base and receives the leak liquid from the pipe that has passed through the drain hole, and
the leak sensor may be provided in the vat.

In this case, the leak liquid from the pipe can be easily detected in the vat.

(Item 5) In the substrate processing apparatus according to item 4,
the vat may have a tapered shape, and
the leak sensor may be provided at a lowest position in a tapered portion of the vat.

In this case, the leak liquid from the pipe can be more reliably detected in the vat.

(Item 6) In the substrate processing apparatus according to any one of items 1 to 5,
the protective pipe may have a bellows shape.

In this case, the degree of freedom in deformation of the pipe is not limited by the protective pipe. Thus, the nozzle can be more smoothly moved.

(Item 7) The substrate processing apparatus according to item 6 may further include
a holder that holds a valley portion of the bellows of the protective pipe.

In this case, it is possible to easily hold the protective pipe while keeping the flexibility of the protective pipe.

(Item 8) The substrate processing apparatus according to any one of items 1 to 7 may further include
a nozzle head to which a plurality of the nozzles are attached and that is moved by the nozzle driver, and
the protective pipe may surround an outer periphery of a plurality of the pipes that are respectively connected to the plurality of nozzles.

In this case, the substrate can be processed in a short period by the plurality of nozzles. Here, even in a case where any of the pipes is damaged due to rubbing of the pipes, and leakage of liquid occurs, the leak liquid is received by the inner peripheral surface of the protective pipe, thereby preventing scattering of the leak liquid. Also, since the leak liquid is detected by the leak sensor, appropriate measures can be taken. Thus, even in a case where the plurality of pipes are provided in the substrate processing apparatus, an adverse effect caused by the leakage of liquid can be prevented.

While preferred embodiments of the present disclosure have been described above, it is to be understood that variations and modifications will be apparent to those skilled in the art without departing the scope of the present disclosure. The scope of the present disclosure, therefore, is to be determined solely by the following claims.

## Claims

1. A substrate processing apparatus (1) comprising:
a substrate holding device (70);
a nozzle (310) that discharges a processing liquid to a substrate (W) to be processed that is held by the substrate holding device (70);
a pipe (311, 312) connected to the nozzle (310);
a protective pipe (391) having an inner peripheral surface that surrounds an outer periphery of the pipe (311, 312);
a nozzle driver (400) that moves the nozzle; the substrate processing apparatus being **characterized in that** it further comprises
a leak sensor (760) that is provided below the substrate holding device (70) and adapted to detect a leak liquid that is received by the inner peripheral surface of the protective pipe (391) due to leakage of liquid from the pipe, which is guided downwardly by gravity, and is then discharged from the protective pipe (391).

2. The substrate processing apparatus (1) according to claim 1, further comprising
a unit base (600) that has a groove (630) and is arranged below the protective pipe (391),
wherein a drain hole (631) that vertically penetrates the unit base (600) is formed in the groove (630), and
the leak sensor (760) detects the leak liquid from the pipe (311, 312) that has passed through the drain hole (631).

3. The substrate processing apparatus (1) according to claim 2, wherein a part of the pipe (311, 312) is contained in the groove (630) of the unit base (600).

4. The substrate processing apparatus (1) according to claim 2 or 3, further comprising
a vat (700) that is arranged below the unit base (600) and receives the leak liquid from the pipe (311, 312) that has passed through the drain hole (631),
wherein the leak sensor (760) is provided in the vat (700).

5. The substrate processing apparatus (1) according to claim 4, wherein the vat (700) has a tapered shape, and
the leak sensor (760) is provided at a lowest position in a tapered portion of the vat (700).

6. The substrate processing apparatus (1) according to any one of claims 1 to 5, wherein the protective pipe (391) has a bellows shape.

7. The substrate processing apparatus (1) according to claim 6, further comprising a holder (392) that holds a valley portion of the bellows of the protective pipe (391).

8. The substrate processing apparatus (1) according to any one of claims 1 to 7, further comprising
a nozzle (310) head to which a plurality of the nozzles (310) is attached and that is moved by the nozzle driver (400),
wherein the protective pipe (391) surrounds an outer periphery of a plurality of the pipes (311, 312) that are respectively connected to the plurality of nozzles (310).

## Patentansprüche

1. Substratverarbeitungsvorrichtung (1), umfassend:
eine Substrathalteeinrichtung (70);
eine Düse (310), die eine Verarbeitungsflüssigkeit an ein zu verarbeitendes Substrat (W) ausstößt, das von der Substrathalteeinrichtung (70) gehalten wird;
ein Rohr (311, 312), das mit der Düse (310) verbunden ist;
ein Schutzrohr (391), das eine Innenumfangsfläche aufweist, die einen Außenumfang des Rohrs (311, 312) umgibt;
einen Düsenantrieb (400), der die Düse bewegt; wobei die Substratverarbeitungsvorrichtung **dadurch gekennzeichnet ist, dass** diese ferner umfasst:
einen Leckagesensor (760), der unterhalb der Substrathalteeinrichtung (70) vorgesehen und dazu eingerichtet ist, eine Leckageflüssigkeit zu detektieren, die von der Innenumfangsfläche des Schutzrohrs (391) aufgrund eines Austretens von Flüssigkeit aus dem Rohr aufgenommen wird, durch die Schwerkraft nach unten geführt und anschließend aus dem Schutzrohr (391) ausgestoßen wird.

2. Substratverarbeitungsvorrichtung (1) nach Anspruch 1, ferner umfassend
eine Einheitsbasis (600), die eine Nut (630) aufweist und unterhalb des Schutzrohrs (391) angeordnet ist,
wobei ein Abflussloch (631), das die Einheitsbasis (600) vertikal durchdringt, in der Nut (630) ausgebildet ist, und
der Leckagesensor (760) die Leckageflüssigkeit aus dem Rohr (311, 312) detektiert, die durch das Abflussloch (631) hindurchgetreten ist.

3. Substratverarbeitungsvorrichtung (1) nach Anspruch 2, wobei ein Teil des Rohrs (311, 312) in der Nut (630) der Einheitsbasis (600) enthalten ist.

4. Substratverarbeitungsvorrichtung (1) nach Anspruch 2 oder 3, ferner umfassend
eine Wanne (700), die unterhalb der Einheitsbasis (600) angeordnet ist und die Leckageflüssigkeit aus dem Rohr (311, 312) aufnimmt, die durch das Abflussloch (631) hindurchgetreten ist,
wobei der Leckagesensor (760) in der Wanne (700) vorgesehen ist.

5. Substratverarbeitungsvorrichtung (1) nach Anspruch 4, wobei die Wanne (700) eine sich verjüngende Form aufweist, und
der Leckagesensor (760) an einer niedrigsten Position in einem sich verjüngenden Abschnitt der Wanne (700) vorgesehen ist.

6. Substratverarbeitungsvorrichtung (1) nach einem der Ansprüche 1 bis 5, wobei das Schutzrohr (391) eine Balgform aufweist.

7. Substratverarbeitungsvorrichtung (1) nach Anspruch 6, ferner umfassend einen Halter (392), der einen Talabschnitt des Balgs des Schutzrohrs (391) hält.

8. Substratverarbeitungsvorrichtung (1) nach einem der Ansprüche 1 bis 7, ferner umfassend
einen Düsenkopf (310), an dem eine Vielzahl der Düsen (310) angebracht ist und der durch den Düsenantrieb (400) bewegt wird,
wobei das Schutzrohr (391) einen Außenumfang einer Vielzahl der Rohre (311, 312) umgibt, die jeweils mit der Vielzahl der Düsen (310) verbunden sind.

## Revendications

1. Appareil de traitement de substrat (1) comprenant :
un dispositif de maintien de substrat (70) ;
une buse (310) qui évacue un liquide de traitement sur un substrat (W) à traiter qui est maintenu par le dispositif de maintien de substrat (70) ;
un tuyau (311, 312) raccordé à la buse (310) ;
un tuyau de protection (391) ayant une surface périphérique intérieure qui entoure une périphérie extérieure du tuyau (311, 312) ;
un dispositif d'entraînement de buse (400) qui déplace la buse ; l'appareil de traitement de substrat étant **caractérisé en ce qu'**il comprend en outre
un capteur de fuite (760) qui est prévu sous le dispositif de maintien de substrat (70) et adapté pour détecter un liquide de fuite qui est reçu par la surface périphérique intérieure du tuyau de protection (391) en raison d'une fuite de liquide du tuyau, qui est guidé vers le bas par la gravité, et est ensuite évacué du tuyau de protection (391).

2. Appareil de traitement de substrat (1) selon la revendication 1, comprenant en outre
une base d'unité (600) qui a une rainure (630) et est agencée sous le tuyau de protection (391),
dans lequel un trou de drainage (631) qui pénètre verticalement dans la base d'unité (600) est formé dans la rainure (630), et
le capteur de fuite (760) détecte le liquide de fuite provenant du tuyau (311, 312) qui a traversé le trou de drainage (631).

3. Appareil de traitement de substrat (1) selon la revendication 2, dans lequel une partie du tuyau (311, 312) est contenue dans la rainure (630) de la base d'unité (600).

4. Appareil de traitement de substrat (1) selon la revendication 2 ou 3, comprenant en outre
une cuve (700) qui est agencée sous la base d'unité (600) et reçoit le liquide de fuite provenant du tuyau (311, 312) qui a traversé le trou de drainage (631),
dans lequel le capteur de fuite (760) est prévu dans la cuve (700).

5. Appareil de traitement de substrat (1) selon la revendication 4, dans lequel la cuve (700) a une forme conique, et
le capteur de fuite (760) est prévu à la position la plus basse dans une partie conique de la cuve (700).

6. Appareil de traitement de substrat (1) selon l'une quelconque des revendications 1 à 5, dans lequel le tuyau de protection (391) a une forme de soufflet.

7. Appareil de traitement de substrat (1) selon la revendication 6, comprenant en outre un élément de maintien (392) qui maintient une partie en creux du soufflet du tuyau de protection (391).

8. Appareil de traitement de substrat (1) selon l'une quelconque des revendications 1 à 7, comprenant en outre
une tête de buses (310) à laquelle est fixée une pluralité de buses (310) et qui est déplacée par le dispositif d'entraînement de buse (400),
dans lequel le tuyau de protection (391) entoure une périphérie extérieure d'une pluralité de tuyaux (311, 312) qui sont respectivement raccordés à la pluralité de buses (310).
